(19) Europäisches Patentamt
European Patent Office
Office européen des brevets

(11) **EP 4 629 298 A1**

(12) **EUROPEAN PATENT APPLICATION**

(43) Date of publication:
**08.10.2025 Bulletin 2025/41**

(21) Application number: **24216980.3**

(22) Date of filing: **03.12.2024**

(51) International Patent Classification (IPC):
*H01M 4/04* (2006.01)    *G01B 11/24* (2006.01)
*G06T 7/62* (2017.01)    *H01M 4/139* (2010.01)
*H01M 10/0525* (2010.01)    *H01M 4/02* (2006.01)

(52) Cooperative Patent Classification (CPC):
**H01M 4/0404; G01B 11/24; G06T 7/62;**
**H01M 4/139; H01M 10/0525;** H01M 2004/021

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **07.04.2024 CN 202410410696**
**16.07.2024 PCT/CN2024/105763**

(71) Applicant: **Eve Power Co., Ltd.**
**Jingmen, Hubei 448000 (CN)**

(72) Inventors:
• **CHENG, Qingshun**
**Jingmen, Hubei 448000 (CN)**
• **SU, Bin**
**Jingmen, Hubei 448000 (CN)**
• **ZHAO, Yuhao**
**Jingmen, Hubei 448000 (CN)**
• **CHEN, Liquan**
**Jingmen, Hubei 448000 (CN)**

(74) Representative: **Berggren Oy**
**P.O. Box 16**
**Eteläinen Rautatiekatu 10A**
**00101 Helsinki (FI)**

(54) **METHOD AND APPARATUS FOR DETERMINING BOUNDARY OF ELECTRODE SHEET COATING AND THINNING REGION, ELECTRONIC DEVICE, AND MEDIUM**

(57) The present disclosure provides a method and apparatus (200) for determining a boundary of an electrode sheet coating and thinning region, an electronic device, and a medium, including: obtaining (101) an initial contour curve from a contour curve set of an initial coating and thinning region of a target electrode sheet; determining (102) an initial ratio of negative electrode capacity to positive electrode capacity according to a material region surface density corresponding to a material region in the target electrode sheet and the initial contour curve; and determining (103) the initial contour curve as a boundary of the initial coating and thinning region if the initial ratio of negative electrode capacity to positive electrode capacity satisfies a preset ratio of negative electrode capacity to positive electrode capacity.

EP 4 629 298 A1

**Description**

**TECHNICAL FIELD**

The present disclosure relates to the field of battery technologies, and more particular to a method and apparatus for determining a boundary of an electrode sheet coating and thinning region, an electronic device, and a medium.

**BACKGROUND**

In a process of producing and processing a power battery, a series of processing are generally performed for a substrate, and a process for processing the substrate is generally composed of steps such as coating, drying, and the like. The coating is a basic step in the process of manufacturing a lithium ion battery, and a positive electrode sheet and a negative electrode sheet of the lithium ion battery are obtained by coating a slurry on a foil. However, in order to prevent an edge of the electrode sheet of the battery from being abnormal in the process of manufacturing the electrode sheet with the coating, the edge of the electrode sheet needs to be thinned, and a region where the electrode sheet is thinned is a coating and thinning region. If a thick edge and a bulging edge are caused in the coating process by factors such as a surface tension of the slurry, the quality of the dried sheet and the subsequent processing of the substrate will be directly affected.

**SUMMARY**

In the related art, a boundary of the electrode sheet coating and thinning region is directly set by means of experience, so that the accuracy of the boundary of the electrode sheet coating and thinning region cannot be ensured, and the thinner or thicker edge of the electrode sheet coating and thinning region is easily present. As such, the boundary of the electrode sheet coating and thinning region is designed unreasonably, affecting more lithium precipitation or insufficient lithium embedding at an edge of an electrode sheet of a battery cell and being not conducive to improving electrical performance and safety performance of the battery cell.

In a first aspect, an embodiment of the present disclosure provides a method for determining a boundary of an electrode sheet coating and thinning region, including:

obtaining at least one contour curve constituting a topographic contour of a thinning region from a contour curve set corresponding to an initial coating and thinning region of a target electrode sheet as an initial contour curve, where the contour curve set includes a plurality of contour curves constituting topographic contours of a plurality of thinning regions;

determining an initial ratio of negative electrode capacity to positive electrode capacity corresponding to the target electrode sheet according to a material region surface density corresponding to a material region in the target electrode sheet and the initial contour curve; and

determining the initial contour curve as a boundary of the initial coating and thinning region if the initial ratio of negative electrode capacity to positive electrode capacity satisfies a preset ratio of negative electrode capacity to positive electrode capacity.

In a second aspect, another embodiment of the present disclosure provides an apparatus for determining a boundary of an electrode sheet coating and thinning region, including:

an obtaining module for obtaining at least one contour curve constituting a topographic contour of a thinning region from a contour curve set corresponding to an initial coating and thinning region of a target electrode sheet as an initial contour curve, where the contour curve set includes a plurality of contour curves constituting topographic contours of a plurality of thinning regions;

a first determination module for determining an initial ratio of negative electrode capacity to positive electrode capacity corresponding to the target electrode sheet according to a material region surface density corresponding to a material region in the target electrode sheet and the initial contour curve; and

a second determination module for determining the initial contour curve as a boundary of the initial coating and thinning region if the initial ratio of negative electrode capacity to positive electrode capacity satisfies a preset ratio of negative electrode capacity to positive electrode capacity.

In a third aspect, yet another embodiment of the present disclosure provides an electronic device, including:

one or more processors;
a memory; and

one or more application programs, where the one or more application programs are stored in the memory and configured to be executed by the processors to implement steps in the method for determining the boundary of the electrode sheet coating and thinning region of any of the first aspects.

In a fourth aspect, the present disclosure further provides a computer readable storage medium having stored thereon a computer program loaded by a processor to perform steps in the method for determining the boundary of the electrode sheet coating and thinning region according to any one of the first aspects.

In a fifth aspect, the present disclosure further provides a computer program product, including computer programs/instructions executable by a processor to perform steps in the method for determining the boundary of the electrode sheet coating and thinning region of any of the first aspects.

Beneficial Effects

The beneficial effects of the present disclosure are as follows:

in the embodiments of the present disclosure, the initial contour curve corresponding to the initial coating and thinning region of the electrode sheet is obtained, the initial ratio of negative electrode capacity to positive electrode capacity of the target electrode sheet is determined according to the initial contour curve, and when the initial positive negative capacity ratio satisfies the condition, the initial contour curve is used as the boundary of the electrode sheet coating and thinning region of the electrode sheet. Since the initial contour curve quantitatively represents the contour of the thinning region and the boundary of the coating and thinning region is determined based on the initial contour curve, accuracy of designing the boundary of the coating and thinning region is ensured, and rationality verification is performed by using the ratio of negative electrode capacity to positive electrode capacity, thereby improving rationality of designing the boundary of the coating and thinning region and further improving electrical performance and safety performance of the battery cell.

## DESCRIPTION OF THE DRAWINGS

FIG. 1 is a schematic flow diagram of a method for determining a boundary of an electrode sheet coating and thinning region according to some embodiments of the present disclosure.

FIG. 2 is a schematic diagram of a target electrode sheet provided in some embodiments of the present disclosure.

FIG. 3 is a schematic diagram of a contour curve set provided in some embodiments of the present disclosure.

FIG. 4 is another schematic flow diagram of a method for determining a boundary of an electrode sheet coating and thinning region according to some embodiments of the present disclosure.

FIG. 5 is yet another schematic flow diagram of a method for determining a boundary of an electrode sheet coating and thinning region according to some embodiments of the present disclosure.

FIG. 6 is yet another schematic flow diagram of a method for determining a boundary of an electrode sheet coating and thinning region according to some embodiments of the present disclosure.

FIG. 7 is a schematic structural diagram of an apparatus for determining a boundary of an electrode sheet coating and thinning region according to some embodiments of the present disclosure.

FIG. 8 is a schematic structural diagram of an electronic device according to some embodiments of the present disclosure.

## DETAILED DESCRIPTION

At present, most of standards of setting the electrode sheet coating and thinning region are mostly determined by means of experience and formulated in combination with an actual verification result of a supplier for providing a gasket of an electrode sheet of the battery cell. Generally, a width difference and a thickness difference of a start point of the coating and thinning region and an end point of a material region are taken as the boundary of the coating and thinning region, provided there is no problem of process abnormality such as no thick edge at the edge of the electrode sheet (the thick edge may mean that the edge thickness of the electrode sheet is greater than that of the material region), no powder falling off (edge thinning transition smoothing), and the like. The method of determining the boundary of the coating and thinning region results in that the standard of designing the coating and thinning region is too wide, and the rationality of designing the boundary of the coating and thinning region cannot be effectively verified. As a result, the thinning region is often not enough thin or too thin in the production process. Therefore, the present application provides a method and apparatus for determining a boundary of an electrode sheet coating and thinning region, an electronic device, and a medium, so as to improve rationality of designing the boundary of the coating and thinning region, and improve electrical performance and safety performance of the battery cell.

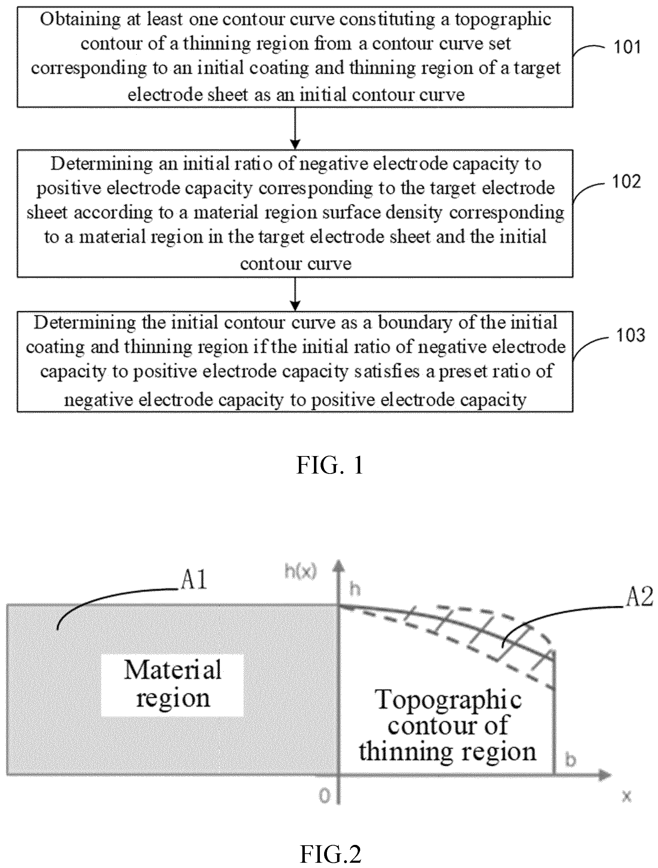

As shown in FIG. 1, which is a schematic flow diagram of a method for determining a boundary of an electrode sheet coating and thinning region according to some embodiments of the present disclosure. The method for determining the boundary of the electrode sheet coating and thinning region may be performed by a device for screening poor coating of a battery electrode sheet. The method for determining the boundary of the electrode sheet coating and thinning region may be integrated into an electronic device, and implemented in a software and/or hardware. The method for determining the boundary of the electrode sheet coating and thinning region includes following steps 101-103.

At step 101, at least one contour curve constituting a topographic contour of a thinning region is obtained from a contour curve set corresponding to an initial coating and thinning region of a target electrode sheet as an initial contour curve, where the contour curve set includes a plurality of contour curves constituting topographic contours of a plurality of thinning regions.

The target electrode sheet may be an electrode sheet of a lithium ion battery cell, where the electrode sheet of the battery cell is composed of a positive electrode sheet and a negative electrode sheet. The target electrode sheet includes a coating and thinning region and a material region, that is, the positive electrode sheet and the negative electrode sheet each include a coating and thinning region and a material region, where the coating and thinning region refers to a region in which a coating process and a thinning process are performed. In the present embodiment, the initial coating and thinning region is a thinning region with qualified edge of the electrode sheet and can be determined by detecting an edge of a given original thinning region. Alternatively, a data sample library with qualified edge of the electrode sheet can be obtained, and the data corresponding to the original thinning region is compared with the data sample library, so that the thinning region with qualified edge of the electrode sheet can be selected as the initial coating and thinning region.

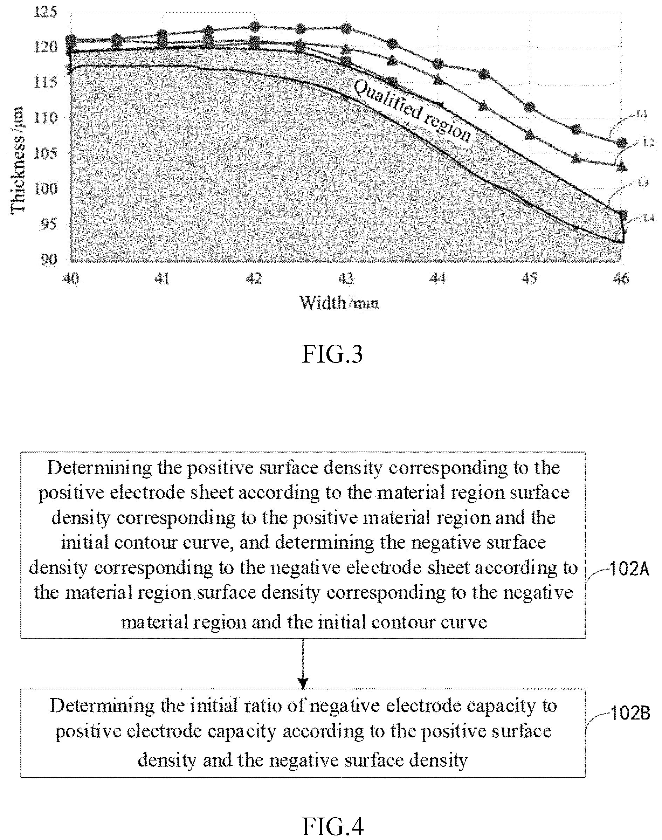

The initial contour curve is a curve representing the contour of the initial coating and thinning region, i.e., the boundary of the initial coating and thinning region. As shown in FIG. 2, which is a schematic diagram of a target electrode sheet, where A1 represents a material region, and A2 represents a topographic contour of a thinning region. The initial contour curve is at least one contour curve constituting a topographical contour of a thinning region, where the contour curve constituting the topographical contour of the thinning region may be one, two or more, provided that the topographical contour of the thinning region can be constituted. In the case of one contour curve, one contour curve may be selected in advance, and the selected contour curve and one contour curve in the contour curve set constitute a topographical contour of a thinning region. Alternatively, two contour curves having the largest surrounding area can be selected from the plurality of contour curves constituting the topographic contour of the plurality of thinning regions as the initial contour curve, where the two contour curves include an initial upper limit contour curve and an initial lower limit contour curve, and an area of a region between the initial upper limit contour curve and the lower limit contour curve is greater than an area of a region between two contour curves constituting the topographic contour of any one of the thinning regions. Thus, it is possible to ensure that the range of the boundary of the firstly determined initial coating and thinning region is maximized, so as to improve the efficiency of the boundary of the initial coating and thinning region. As shown in FIG. 3, which is a schematic diagram of a contour curve set, where L1, L2, L3, and L4 represent contour curves, a region surrounded by L1 and L4 has the largest area, L1 represents the initial upper limit contour curve, and L4 represents the initial lower limit contour curve.

Specifically, the method for determining the boundary of the electrode sheet coating and thinning region further includes: before the step 101, determining an initial coating and thinning region of the target electrode sheet; performing a scanning test on the initial coating and thinning region and the material region in the target electrode sheet to measure a width of the initial coating and thinning region and a thickness of the material region; and performing curve fitting by taking the widths of the initial coating and thinning regions as an independent variable and the thicknesses of the material regions as a dependent variable based on the plurality of groups of the widths of the initial coating and thinning region and the thicknesses of the material region to obtain the contour curve set.

Specifically, the original thinning region of the target electrode sheet can be obtained by means of manual experience, and then the edge of the original thinning region is detected, so that the original thinning region with qualified edge of the electrode sheet can be screened out as the initial coating and thinning region, or the initial coating and thinning region of the target electrode sheet can be stored in a memory of a terminal in advance to directly obtain the initial coating and thinning region. Then, an on-line detection device, such as a laser contour tester, transversely scans the material region and the initial coating and thinning region of the target electrode sheet at a predetermined speed, so as to measure thickness data of the target electrode sheet in an its width direction, that is, obtain the width (denoted by b) of the initial coating and thinning region and the thickness (denoted by h) of the material region, where each data point is spaced 0.5mm~1mm. Then, curve fitting is performed with the width b as an independent variable and the thickness h as a dependent variable to obtain a plurality of contour curves b=h(x), and at least one contour curve constituting a topographic contour of a thinning region in the contour curve set is used as the initial contour curve.

It should be understood in the present embodiment that the contour of the initial coating and thinning region is quantitatively characterized by measuring continuous width data of the initial coating and thinning region with qualified edge of the electrode sheet and the thickness data of the material region, overcoming the problem that the contour of the initial coating and thinning region is inaccurate by means of experience in the conventional solution. Meanwhile, the contour of the initial coating and thinning region is theoretically characterized by data, and the initial contour curve is determined by continuous function fitting, so as to improve the accuracy of the initial contour curve and subsequently improve the accuracy of the boundary of the coating and thinning region of the target electrode sheet based on the initial contour curve.

At step 102, an initial ratio of negative electrode capacity to positive electrode capacity corresponding to the target electrode sheet is determined according to a material region surface density corresponding to a material region in the target electrode sheet and the initial contour curve.

Where, the ratio of negative electrode capacity to positive electrode capacity (i.e., Cell Balance, CB value), also referred to as Negative/Positive (N/P) is a ratio of the capacity of the cathode active material to the capacity of the anode active material in the same time period under the same condition.

A region of the target electrode sheet that does not contain the initial coating and thinning region is a material region, and the material region is a positive material region and a negative material region, that is, the material region in the positive electrode sheet is a positive material region and the material region in the negative electrode sheet is a negative material region. A material region surface density, gram capacity of the active material, and a percentage of the active material content corresponding to the positive material region, and a material region surface density, gram capacity of the active material, and a percentage of the active material content corresponding to the negative material region have been predetermined in the process of preparing the battery and are all known variables.

In one specific embodiment, the initial ratio of negative electrode capacity to positive electrode capacity, i.e., CB, is calculated as:

$$ \mathrm{CB} = \frac{C.W._{\text{negative}} \times C_{\text{negative\_gram}} \times Wt_{\text{negative}}}{C.W._{\text{positive}} \times C_{\text{positive\_gram}} \times wt_{\text{positive}}} \quad (1); $$

In Equation (1), $C.W._{\text{negative}}$ represents the negative surface density of the negative electrode sheet, $C.W._{\text{negative\_gram}}$ represents the gram capacity of the active material of the negative material region, $wt_{\text{negative}}$ represents the percentage of the active material content of the negative material region, $C.W._{\text{positive}}$ represents the positive surface density of the positive electrode sheet, $C.W._{\text{positive\_gram}}$ represents the gram capacity of the active material of the positive material region, and $wt_{\text{positive}}$ represents the percentage of the active material content of the positive material region.

Since the negative surface density of the negative electrode sheet can be calculated from the material region surface density of the negative material region and the initial contour curve, and the positive surface density of the positive electrode sheet can be calculated from the material region surface density of the positive material region and the initial contour curve, in this embodiment, the negative surface density and the positive surface density can be calculated from the material region surface density corresponding to each of the positive material region and the negative material region and the initial contour curve, so that the initial ratio of negative electrode capacity to positive electrode capacity corresponding to the target electrode sheet can be determined.

Specifically, the step 102 includes: determining the surface density of the target electrode sheet according to the material region surface density corresponding to the material region and the initial contour curve; and determining the initial ratio of negative electrode capacity to positive electrode capacity according to the surface density of the target electrode sheet.

Specifically, the surface density of the target electrode sheet is determined according to the material region surface density corresponding to the material region and the initial contour curve, and after the surface density of the target electrode sheet is determined, the initial ratio of negative electrode capacity to positive electrode capacity may be determined according to the surface density of the target electrode sheet.

Specifically, as shown in FIG. 4, the target electrode sheet includes a positive electrode sheet and a negative electrode sheet, and a material region of the target electrode sheet that does not contain the initial coating and thinning region includes a positive material region of the positive electrode sheet and a negative material region of the negative electrode sheet, and the surface density of the material region includes a material region surface density corresponding to each of the positive material region and the negative material region; and the step 102 includes following steps 102A-102B.

At step 102A, the positive surface density corresponding to the positive electrode sheet is determined according to the material region surface density corresponding to the positive material region and the initial contour curve, and the negative surface density corresponding to the negative electrode sheet is determined according to the material region surface density corresponding to the negative material region and the initial contour curve.

The negative surface density is a sum of the material region surface density corresponding to the negative material region and the surface density corresponding to the negative thinning region, and the positive surface density is a sum of the material region surface density corresponding to the positive material region and the surface density corresponding to the positive thinning region.

In one specific embodiment, the positive surface density and the negative surface density are calculated as follows:

$$C.W._{positive} = C.W._{positive\_material} + C.W._{positive\_thinning} \quad (2);$$

$$|C.W._{negative} = C.W._{negative\_material} + C.W._{negative\_thinning} \quad (3);$$

In equations (2) and (3), $C.W._{negative\_material}$ represents the material region surface density corresponding to the negative material region, $C.W._{negative\_thinning}$ represents the surface density corresponding to the negative thinning region, $C.W._{positive\_material}$ represents the material region surface density corresponding to the positive material region, and $C.W._{positive\_thinning}$ represents the surface density corresponding to the positive thinning region.

Since the surface density corresponding to the negative thinning region can be calculated from the material region surface density corresponding to the negative material region and the initial contour curve, and the surface density corresponding to the positive thinning region can be calculated from the material region surface density corresponding to the positive material region and the initial contour curve, the negative surface density and the positive surface density can be calculated from the material region surface density corresponding to each of the positive material region and the negative material region and the initial contour curve.

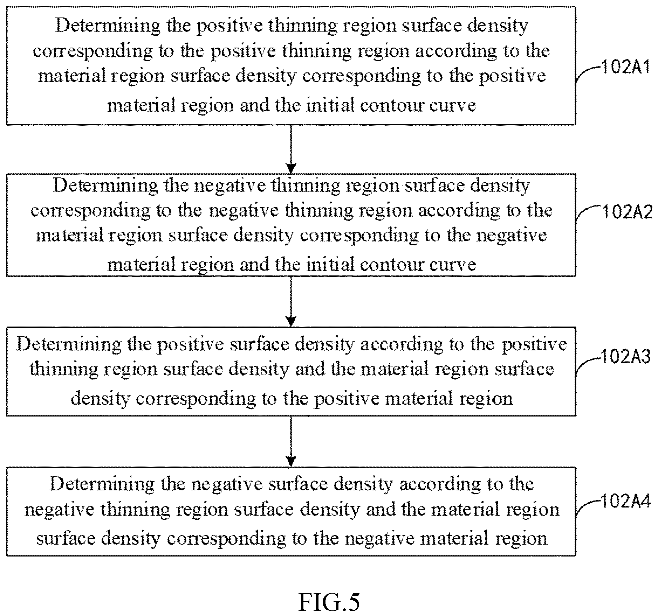

Specifically, as shown in FIG. 5, the initial coating and thinning region includes a positive thinning region corresponding to the positive electrode sheet and a negative thinning region corresponding to the negative electrode sheet; and the step 102A includes following steps 102A1-102A4.

At the step 102A1, the positive thinning region surface density corresponding to the positive thinning region is determined based on the material region surface density corresponding to the positive material region and the initial contour curve.

Specifically, the material region surface density of the initial coating and thinning region can be calculated by the known surface density of the material region, and converted into the ratio of the surface region to the cross-sectional area of the initial coating and thinning region according to the coating film height, the coating film length, and the ratio of the width of the initial coating and thinning region to the thickness of the material region, where

$$\frac{C.W._{thinning}}{C.W._{material}} = \frac{\frac{m_{thinning}}{s_{thining\_surface}}}{\frac{m_{material}}{s_{material\_surface}}} = \frac{\rho \times a \times s_{thinning\_cross\_sectional} / s_{thinning\_surface}}{\rho \times a \times s_{material\_cross\_sectional} / s_{material\_surface}} =$$

$$\frac{a \times s_{thinning\_cross\_sectional} / s_{thinning\_surface}}{h} = \frac{s_{thinning\_cross\_sectional}}{bh} \quad (4)$$

In Equation (4), $h$ represents the thickness of the material region, $C.W._{thinning}$ represents the surface density of the initial coating and thinning region, $C.W._{material}$ represents the material region surface density of the material region, $\rho$ represents the density of the target electrode sheet, $s_{thinning\_cross\_sectional}$ represents the cross-sectional area of the initial coating and thinning region, $s_{material\_cross\_sectionai}$ represents the cross-sectional area of the material region, $s_{thinning\_surface}$ represents the surface area of the initial coating and thinning region, $s_{thinning\_surface} = ab$, $s_{material\_surface}$ represents the surface area of the material region, $a$ represents the length of the target electrode sheet, and $b$ represents the width of the initial coating and thinning region.

The conversion process is performed by putting $s_{thinning\_surface}$ into the above equation (4), and it can be seen that

$$C.W._{thinning} = \frac{C.W.material}{bh} \times s_{thinning\_cross\_sectional}$$

The initial coating and thinning region includes the positive thinning region and the negative thinning region. For the positive thinning region surface density, $C.W._{\text{thinning}}$ in the above equation may be replaced with $C.W._{\text{positive\_thinning}}$, $C.W._{\text{material}}$ in the above equation may be replaced with $C.W._{\text{positive-material}}$, and $s_{\text{thinning\_cross\_sectional}}$ in the above equation may be replaced with $s_{\text{positive\_thinning\_cross\_sectional}}$. For example, $c.w._{\text{positive\_thinning}} = \dfrac{C.W._{\text{positive\_material}}}{b_{\text{positive}} h_{\text{positive}}} \times s_{\text{positive\_thinning\_cross\_sectional}}$, where, $b_{\text{positive}}$ represents the width of the positive thinning region, $h_{\text{positive}}$ represents the thickness of the positive material region, $C.W._{\text{positive\_thinning}}$ represents the surface density of the positive thinning region, $C.W._{\text{positive\_thinning}}$ represents the material region surface density of the positive material region, and $s_{\text{positive\_thinning\_cross\_sectional}}$ represents the cross-sectional area of the positive thinning region.

Since the cross-sectional area of the initial coating and thinning region can be calculated according to an initial contour function, the positive thinning region surface density corresponding to the positive thinning region can be determined based on the material region surface density corresponding to the positive material region and the initial contour curve. Similarly, the negative thinning region surface density corresponding to the negative thinning region can be determined based on the material region surface density corresponding to the negative material region and the initial contour curve.

Specifically, the initial contour curve includes a negative contour curve corresponding to the negative thinning region, and determining the negative thinning region surface density corresponding to the negative thinning region based on the material region surface density corresponding to the negative material region and the initial contour curve includes: determining a negative cross-sectional area of the negative thinning region based on the negative contour curve; and determining the negative thinning region surface density of the negative thinning region based on the negative contour curve, the negative cross-sectional area, and the material region surface density corresponding to the negative material region.

Specifically, for the negative thinning region surface density, $C.W._{\text{thinning}}$ in the above equation $c.w._{\text{thinning}} = \dfrac{C.W._{\text{material}}}{bh} \times s_{\text{thinning\_cross\_sectional}}$ may be replaced with $C.W._{\text{negative\_thinning}}$, $C.W._{\text{material}}$ in the above equation may be replaced with $C.W._{\text{nagative\_material}}$, and $s_{\text{thinning\_cross\_sectional}}$ in the above equation may be replaced with $s_{\text{negative\_thinning\_cross\_sectional}}$. For example, $c.w._{\text{negative\_thinning}} = \dfrac{C.W._{\text{negative\_material}}}{b_{\text{negative}} h_{\text{negative}}} \times s_{\text{negative\_thinning\_cross\_sectional}}$, where, $b_{\text{negative}}$ represents the width of the negative thinning region, $h_{\text{negative}}$ represents the thickness of the negative material region, $C.W._{\text{negative\_thinning}}$ represents the surface density of the negative thinning region, $C.W._{\text{negative\_material}}$ represents the material region surface density of the negative material region, and $s_{\text{negative\_thinning\_cross\_sectional}}$ represents the cross-sectional area of the negative thinning region.

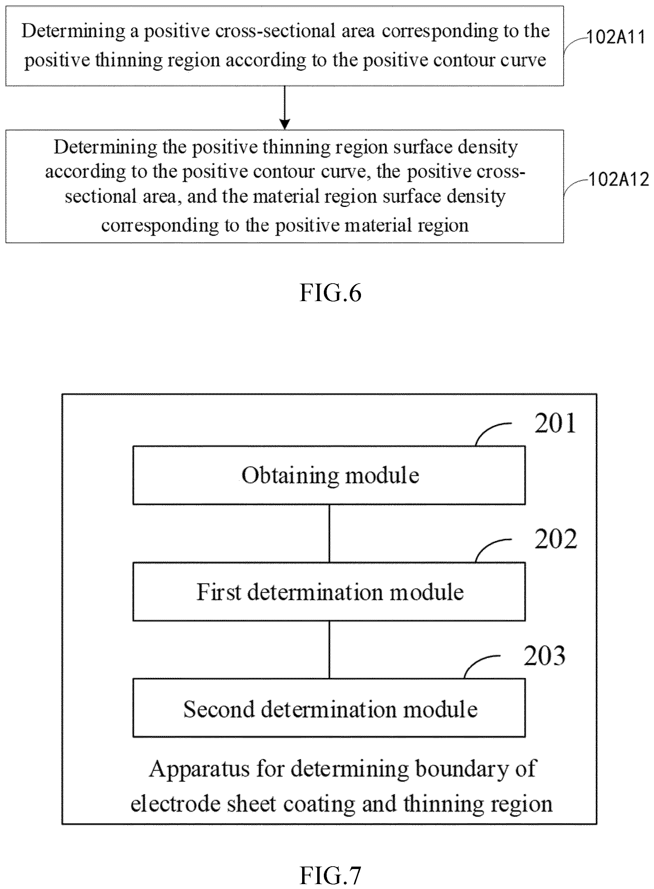

Specifically, as shown in FIG. 6, the initial contour curve includes a positive contour curve corresponding to the positive thinning region, and the step 102A1 includes following steps 102A11-102A12.

At the step 102A11, a positive cross-sectional area corresponding to the positive thinning region is determined based on the positive contour curve.

Specifically, the step 102A11 includes: performing integral calculation on the positive contour curve to obtain the positive cross-sectional area.

Correspondingly, the initial contour curve further includes a negative contour curve corresponding to the negative thinning region.

Where the initial contour curve h(x) includes a positive contour curve $h_{\text{positive}}$ (x) corresponding to the positive thinning region and a negative contour curve $h_{\text{negative}}$ (x) corresponding to the negative thinning region.

Specifically, the cross-sectional area of the initial coating and thinning region is the integral of the initial contour curve h(x), i.e., $s_{\text{thinning\_cross\_sectional}} = \int_0^b h(x)\, dx$. The positive cross-sectional area can be calculated by following equation $s_{\text{positive\_thinning\_cross\_sectional}} = \int_0^{b_{\text{positive}}} h_{\text{positive}}(x)\, dx$.

Correspondingly, the negative cross-sectional area can be calculated by $s_{\text{negative\_thinning\_cross\_sectional}} = \int_0^{b_{\text{negative}}} h_{\text{negative}}(x)\, dx$.

At the step 102A12, the positive thinning region surface density is determined based on the positive contour curve, the positive cross-sectional area, and the material region surface density corresponding to the positive material region.

Specifically, the step 102A12 includes: obtaining interval endpoint values corresponding to an independent variable in the positive contour curve; determining interval endpoint values corresponding to a dependent variable in the positive contour curve based on the interval endpoint values corresponding to the independent variable in the positive contour curve; determining a width of the initial coating and thinning region and a thickness of the positive material region based on the interval endpoint values corresponding to each of the independent variable and the dependent variable in the positive electrode contour curve, to obtain a width value corresponding to the positive coating and thinning region and a thickness value corresponding to the positive material region; and determining the surface density of the positive thinning region according to a product of the width value corresponding to the positive coating and thinning region and the thickness value corresponding to the positive material region, the material region surface density of the positive material region, and the positive cross-sectional area.

Specifically, the dependent variable of the positive contour curve, such as, $h_{positive}$, is calculated by putting $b_{positive}$ into the positive contour curve based on the interval endpoint values corresponding to the independent variable in the positive contour curve, such as $[0, b_{positive}]$, to obtain the width $b_{positive}$ of the positive thinning region and the thickness

$$c.W._{positive\_thinning} = \frac{C.W._{positive\_material}}{b_{positive}h_{positive}} \times$$

$h_{positive}$ of the positive material region.

$$\int_0^{b_{positive}} h_{positive}(x)\,dx$$ can be calculated by putting the positive cross-sectional area into the calculation equation of the surface density of the positive thinning region $c.w._{positive\_thinning} = \frac{C.W._{positive\_material}}{b_{positive}h_{positive}} \times S_{positive\_thinning\_cross\_sectional}$.

Specifically, determining the negative thinning region surface density based on the negative contour curve, the negative cross-sectional area, and the material region surface density corresponding to the negative material region includes: obtaining interval endpoint values corresponding to an independent variable in the negative contour curve; determining interval endpoint values corresponding to a dependent variable in the negative contour curve based on the interval endpoint values corresponding to the independent variable in the negative contour curve; determining a width of the initial coating and thinning region and a thickness of the negative material region based on the interval endpoint values corresponding to each of the independent variable and the dependent variable in the negative electrode contour curve, to obtain a width value corresponding to the negative coating and thinning region and a thickness value corresponding to the negative material region; and determining the negative thinning region surface density according to a product of the width value corresponding to the negative coating and thinning region and the thickness corresponding to the negative material region, the material region surface density of the negative material region, and the negative cross-sectional area.

Specifically, the dependent variable of the negative contour curve, such as, $h_{negative}$, is calculated by putting $b_{negative}$ into the negative contour curve based on the interval endpoint values corresponding to the independent variable in the negative contour curve, such as $[0, b_{negative}]$, to obtain the width $b_{negative}$ of the negative thinning region and the

$$c.W._{negative\_thinning} = \frac{C.W._{negative\_material}}{b_{negative}h_{negative}} \times$$

thickness $h_{negative}$ of the negative material region.

$$\int_0^{b_{negative}} h_{negative}(x)\,dx$$ can be calculated by putting the negative cross-sectional area into the calculation equation of the surface density of the negative thinning region $c.w._{negative\_thinning} = \frac{C.W._{negative\_material}}{b_{negative}h_{negative}} \times S_{negative\_thinning\_cross\_sectional}$.

At the step 102A2, the negative thinning region surface density corresponding to the negative thinning region is determined based on the material region surface density corresponding to the negative material region and the initial contour curve.

Specifically, since a manner of calculating the negative thinning region surface density is consistent with that of calculating the positive thinning region surface density, an equation for calculating the negative thinning region surface density is as follows:

$$c.w._{\text{negative\_thinning}} = \frac{c.w._{\text{negative\_material}}}{b_{\text{negative}}h_{\text{negative}}} \times s_{\text{negative\_thinning\_cross\_sectional}} =$$

$$\frac{c.w._{\text{negative\_material}}}{b_{\text{negative}}h_{\text{negative}}} \times \int_0^{b_{\text{negative}}} h_{\text{negative}}(x)\, dx \quad (5)$$

In equation (5), $b_{\text{negative}}$ represents the width of the negative thinning region, and $h_{\text{negative}}$ represents the thickness of the negative material region,

$c.w._{\text{negative\_thinning}}$ represents the negative thinning region surface density, $c.w._{\text{negative\_material}}$ represents the material region surface density of the negative material region, and $s_{negative\_thinning\_cross\_sectional}$ represents the cross-sectional area of the negative thinning region.

At the step 102A3, the positive surface density is determined based on the positive thinning region surface density and the material region surface density corresponding to the positive material region.

Specifically, the positive surface density is a sum of the positive thinning region surface density and the material region surface density of the positive material region, i.e.,

$$|c.w._{\text{·positive}} = c.w._{\text{·positive\_material}} + c.w._{\text{·positive\_thinning}} =$$

$$\frac{c.w._{\text{·positive\_material}}}{b_{positive}h_{positive}} \times \int_0^{b_{positive}} h_{positive}(x)\, dx + c.w._{\text{·positive\_material}} = [1 +$$

$$\frac{1}{b_{positive}h_{positive}} \times \int_0^{b_{positive}} h_{positive}(x)\, dx] \times c.w._{\text{·positive\_material}} \quad (5).$$

At the step 102A4, the negative surface density is determined based on the negative thinning region surface density and the material region surface density corresponding to the negative material region.

Specifically, similarly to the step 102A3, the negative surface density is a sum of the negative thinning region surface density and the material region surface density corresponding to the negative material region, i.e.,

$$c.w._{\text{·negative}} = c.w._{\text{·negative\_material}} + c.w._{\text{·negative\_thinning}} =$$

$$\frac{c.w._{\text{·negative\_material}}}{b_{negative}h_{negative}} \times \int_0^{b_{negative}} h_{negative}(x)\, dx + c.w._{\text{·negative\_material}} = \left[1 +\right.$$

$$\left.\frac{1}{b_{negative}h_{negative}} \times \int_0^{b_{negative}} h_{negative}(x)\, dx\right] \times c.w._{\text{·negative\_material}} \cdot$$

At the step 102B, the initial ratio of negative electrode capacity to positive electrode capacity is determined based on the positive surface density and the negative surface density.

Specifically, after the positive surface density and the negative surface density are determined, the initial ratio of negative electrode capacity to positive electrode capacity is determined according to the gram capacity of the active material and a percentage of the active material content corresponding to each of the positive material region and the negative material region, the positive surface density, and the negative surface density, that is, the initial ratio of negative electrode capacity to positive electrode capacity CB can be calculated. An equation for calculating the initial ratio of negative electrode capacity to positive electrode capacity is as follows.

$$CB =$$

$$\frac{[1 + \frac{1}{b_{\text{negative}}h_{\text{negative}}} \times \int_0^{b_{\text{negative}}} h_{negative}(x)dx] \times c.w._{\text{·negative\_material}} \times C_{\text{negative\_gram}} \times wt_{\text{negative}}}{[1 + \frac{1}{b_{\text{positive}}h_{\text{positive}}} \times \int_0^{b_{\text{positive}}} h_{positive}(x)dx] \times c.w._{\text{·positive\_material}} \times C_{\text{positive\_gram}} \times wt_{\text{positive}}} \quad (6)$$

It can be understood in the present embodiment that the initial ratio of negative electrode capacity to positive electrode capacity can be calculated from the initial contour curve, and since the initial contour curve is more accurate, the initial ratio of negative electrode capacity to positive electrode capacity is also more accurate, thereby improving the accuracy of calculating the initial ratio of negative electrode capacity to positive electrode capacity.

It should be noted that the initial contour curve includes an initial upper limit contour curve and an initial lower limit contour curve; the positive contour curve $h_{positive}(x)$ includes a positive upper limit contour curve $h_{1positive}(x)$ and a positive lower limit contour curve $h_{2positive}(x)$; and the negative contour curve $h_{negative}(x)$ includes a negative upper limit contour curve $h_{1negative}(x)$ and a negative lower limit contour curve $h_{2negative}(x)$. In order to ensure the accuracy of the subsequent verification of the initial ratio of negative electrode capacity to positive electrode capacity, the maximum value CBmax and the minimum value CBmin of the initial ratio of negative electrode capacity to positive electrode capacity can be calculated:

$$CBmax = \frac{[1+\frac{1}{b_{negative}h_{negative}}\times\int_0^{b_{negative}} h_{1negative}(x)dx)]\times c.w._{negative\_material}\times C_{negative\_gram}\times wt_{negative}}{[1+\frac{1}{b_{positive}h_{positive}}\times\int_0^{b_{positive}} h_{2positive}(x)dx]\times c.w._{positive\_material}\times C_{positive\_gram}\times wt_{positive}} \quad (7)$$

$$CBmin = \frac{[1+\frac{1}{b_{negative}h_{negative}}\times\int_0^{b_{negative}} h_{2negative}(x)dx]\times c.w._{negative\_material}\times C_{negative\_gram}\times wt_{negative}}{[1+\frac{1}{b_{positive}h_{positive}}\times\int_0^{b_{positive}} h_{1positive}(x)dx]\times c.w._{positive\_material}\times C_{positive\_gram}\times wt_{positive}} \quad (8)$$

At the step 103, if the initial ratio of negative electrode capacity to positive electrode capacity satisfies a preset ratio of negative electrode capacity to positive electrode capacity, the initial contour curve is determined as a boundary of the initial coating and thinning region.

Where the preset ratio of negative electrode capacity to positive electrode capacity is a preset ratio threshold of negative electrode capacity to positive electrode capacity for determining whether the initial coating and thinning region is accurate. In the present embodiment, the preset ratio of negative electrode capacity to positive electrode capacity CB0 includes a lower limit value CB0min and an upper limit value CB0max of the ratio of negative electrode capacity to positive electrode capacity.

Specifically, when the maximum value of the initial ratio of negative electrode capacity to positive electrode capacity is less than the upper limit value of the ratio of negative electrode capacity to positive electrode capacity and the minimum value of the initial ratio of negative electrode capacity to positive electrode capacity is greater than the lower limit value of the ratio of negative electrode capacity to positive electrode capacity, that is, CBmax<CB0max and CBmin>CB0-min, it is determined that the initial ratio of negative electrode capacity to positive electrode capacity satisfies the preset ratio of negative electrode capacity to positive electrode capacity, indicating that the initial contour curve satisfies the electrode sheet coating process condition. Therefore, the initial contour curve is determined as the boundary of the initial coating and thinning region, thereby determining the boundary of the coating and thinning region of the target electrode sheet.

Specifically, the method further includes: if the initial ratio of negative electrode capacity to positive electrode capacity does not satisfy the preset ratio of negative electrode capacity to positive electrode capacity, obtaining at least one contour curve constituting a topographic contour of next thinning region from the contour curve set corresponding to the initial coating and thinning region of the target electrode sheet as the initial contour curve, until the boundary of the initial coating and thinning region is determined.

Specifically, if the initial ratio of negative electrode capacity to positive electrode capacity does not satisfy the preset ratio of negative electrode capacity to positive electrode capacity, at least one contour curve constituting a topographic contour of next thinning region is obtained from the contour curve set corresponding to the initial coating and thinning region of the target electrode sheet as the initial contour curve, and the step of determining the initial ratio of negative electrode capacity to positive electrode capacity corresponding to the target electrode sheet according to the material region surface density corresponding to the material region in the target electrode sheet and the initial contour curve is performed, until the boundary of the initial coating and thinning region is determined.

More specifically, when the initial ratio of negative electrode capacity to positive electrode capacity does not satisfy the preset ratio of negative electrode capacity to positive electrode capacity, it indicates that the initial contour curve does not satisfy the electrode sheet coating process condition. In this case, it is necessary to adjust the initial contour curve to obtain at least one contour curve constituting the topographic contour of the thinning region as the initial contour curve, and continue to determine the initial ratio of negative electrode capacity to positive electrode capacity. When at least one curve with the largest surrounding area is selected as the initial contour curve, the original contour curve set can be narrowed, that is, the initial upper limit contour curve or the lower limit contour curve can be deleted to determine the initial contour curve from the remaining contour curve set, i.e., the updated initial contour curve can be obtained, Then the embodiments of steps 102-103 are repeated, until the initial ratio of negative electrode capacity to positive electrode capacity corresponding to the updated initial contour curve satisfies the preset ratio of negative electrode capacity to positive electrode capacity, and the updated initial contour curve is determined as the boundary of the initial coating and thinning region, thereby obtaining the boundary of the initial coating and thinning region.

In one example, a detection device of the laser contourgraph is scanned at a certain speed, and the thickness data of the material region and the thinning region in a transverse direction of the positive and negative electrode sheets of the battery are measured every 0.5 mm, and the fitting function $h(x)=ax^4+bx^3+cx^2+dx+e$ is used. Tabs are protruded on the same side of the battery, where the upper limit contour curve and the lower limit contour curve of the coating and thinning region of the negative electrode sheet of the battery are $h(x)_{negative1}=-0.0220x^4+1.2588x^3-26.8828x^2 +254.2183x-817.4318$ and $h(x)_{negative2}=-0.0150x^4+0.8585x^3-18.3276x^2+ 172.4165x-527.1755$, respectively, and the upper limit contour curve and the lower limit contour curve of the coating and thinning region of the positive electrode sheet of the battery are $h(x)_{positive1}=0.0207x^4-1.1670x^3+23.6862x^2-201.1107x+677.0181$ and $h(x)_{positive2}=-0.0002x^4 +0.0222x^3-0.9451x^2+17.1150x-19.3267$, respectively, the positive thinning region has a width range of 13mm-19mm, and the negative thinning region has a width range of 11.5mm~17.5mm. Other physical variables are known, and CBmin=1.1434, CBmax=1.2492 are calculated to satisfy the CB value management and control requirements. Production of the coating and thinning region is normal, and the upper limit contour curve and the lower limit contour curve of the coating and thinning region of the negative electrode sheet and the upper limit contour curve and the lower limit contour curve of the coating and thinning region of the positive electrode sheet can be used as a boundary model for managing and controlling a standard of the thinning region of the positive and negative electrode sheets of this product model.

According to the method for determining the boundary of the electrode sheet coating and thinning region, the initial contour curve corresponding to the initial coating and thinning region of the electrode sheet is obtained, the initial ratio of negative electrode capacity to positive electrode capacity of the target electrode sheet is determined according to the initial contour curve, and when the initial positive negative capacity ratio satisfies the condition, the initial contour curve is used as the boundary of the electrode sheet coating and thinning region of the electrode sheet. Since the initial contour curve quantitatively represents the contour of the thinning region and the boundary of the coating and thinning region is determined based on the initial contour curve, accuracy of designing the boundary of the coating and thinning region is ensured, and rationality verification is performed by using the ratio of negative electrode capacity to positive electrode capacity, thereby improving rationality of designing the boundary of the coating and thinning region and further improving electrical performance and safety performance of the battery cell.

As shown in FIG. 7, another embodiment of the present disclosure further provides an apparatus 200 for determining a boundary of an electrode sheet coating and thinning region, including:

an obtaining module 201 for obtaining at least one contour curve constituting a topographic contour of a thinning region from a contour curve set corresponding to an initial coating and thinning region of a target electrode sheet as an initial contour curve, where the contour curve set includes a plurality of contour curves constituting topographic contours of a plurality of thinning regions;

a first determination module 202 for determining an initial ratio of negative electrode capacity to positive electrode capacity corresponding to the target electrode sheet according to a material region surface density corresponding to a material region in the target electrode sheet and the initial contour curve; and

a second determination module 203 for determining the initial contour curve as a boundary of the initial coating and thinning region if the initial ratio of negative electrode capacity to positive electrode capacity satisfies a preset ratio of negative electrode capacity to positive electrode capacity.

In some embodiments, the apparatus further includes:

a third determination module for obtaining at least one contour curve constituting a topographic contour of next thinning region from the contour curve set corresponding to the initial coating and thinning region of the target electrode sheet as the initial contour curve in response to the initial ratio of negative electrode capacity to positive electrode capacity not satisfying the preset ratio of negative electrode capacity to positive electrode capacity, until the boundary of the initial coating and thinning region is determined.

In some embodiments, the apparatus further includes:

a fourth determination module for determining an initial coating and thinning region of the target electrode sheet;

a test module for performing a scanning test on the initial coating and thinning region and a material region in the target electrode sheet to measure a plurality of groups of widths of the initial coating and thinning region and thicknesses of the material region; and

a fitting module for performing curve fitting by taking the width of the initial coating and thinning region as an independent variable and the thickness of the material region as a dependent variable based on the plurality of groups of the widths of the initial coating and thinning region and the thicknesses of the material region to obtain the contour curve set.

In some embodiments, the first determination module 202 is further specifically configured to:

determine a surface density of the target electrode sheet based on the material region surface density corresponding to the material region and the initial contour curve; and
determine the initial ratio of negative electrode capacity to positive electrode capacity based on the surface density of the target electrode sheet.

In some embodiments, the target electrode sheet comprises a positive electrode sheet and a negative electrode sheet, the material region of the target electrode sheet comprises a positive material region of the positive electrode sheet and a negative material region of the negative electrode sheet, and the material region surface density comprises a material region surface density corresponding to each of the positive material region and the negative material region; and the first determination module 202 is further specifically configured to:

determine the positive surface density corresponding to the positive electrode sheet based on the material region surface density corresponding to the positive material region and the initial contour curve, and determine the negative surface density corresponding to the negative electrode sheet based on the material region surface density corresponding to the negative material region and the initial contour curve; and
determine the initial ratio of negative electrode capacity to positive electrode capacity based on the positive surface density and the negative surface density.

In some embodiments, the initial coating and thinning region includes a positive thinning region corresponding to the positive electrode sheet and a negative thinning region corresponding to the negative electrode sheet; and the first determination module 202 is further specifically configured to:

determine the positive thinning region surface density corresponding to the positive thinning region based on the material region surface density corresponding to the positive material region and the initial contour curve;
determine the negative thinning region surface density corresponding to the negative thinning region based on the material region surface density corresponding to the negative material region and the initial contour curve;
determine the positive surface density based on the positive thinning region surface density and the material region surface density corresponding to the positive material region; and
determine the negative surface density based on the negative thinning region surface density and the material region surface density corresponding to the negative material region.

In some embodiments, the initial contour curve includes a positive contour curve corresponding to the positive thinning region; and the first determination module 202 is further specifically configured to:

determine a positive cross-sectional area corresponding to the positive thinning region based on the positive contour curve; and
determine the positive thinning region surface density based on the positive contour curve, the positive cross-sectional area, and the material region surface density corresponding to the positive material region.

In some embodiments, the first determination module 202 is further specifically configured to:
perform integral calculation on the positive contour curve to obtain the positive cross-sectional area.
In some embodiments, the first determination module 202 is further specifically configured to:

determine a width of the initial coating and thinning region and a thickness of the positive material region based on the interval endpoint values corresponding to each of the independent variable and the dependent variable in the positive electrode contour curve, to obtain a width value corresponding to the positive coating and thinning region and a thickness value corresponding to the positive material region; and
determine the surface density of the positive thinning region according to a product of the thickness value and the width value, the material region surface density corresponding to the positive material region, and the positive cross-sectional area.

Yet another embodiment of the present disclosure further provides an electronic device that integrates the apparatus for determining the boundary of the electrode sheet coating and thinning region according to any one of the embodiments of the present disclosure, including:

one or more processors;
a memory; and
one or more application programs, wherein the one or more application programs are stored in memory and configured to be executed by the processors to implement steps in the method for determining the boundary of the electrode sheet coating and thinning region according to any one of the embodiments of the present disclosure.

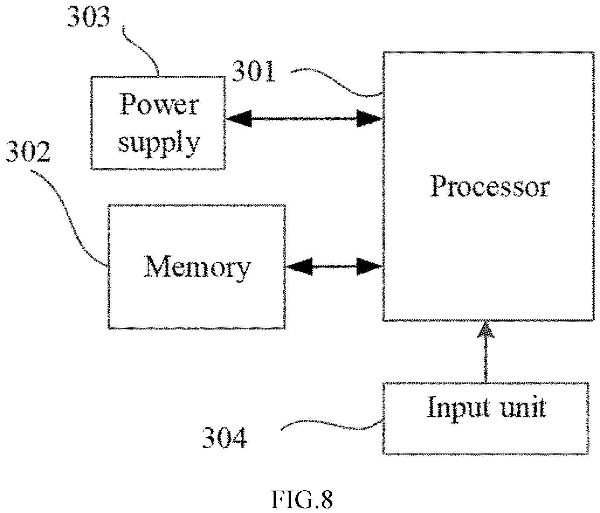

Yet another embodiment of the present disclosure further provides an electronic device that integrates the apparatus for determining the boundary of the electrode sheet coating and thinning region according to any one of the embodiments of the present disclosure. As shown in FIG. 8, which shows a schematic structural diagram of an electronic device according to some embodiments of the present disclosure.

Specifically, the electronic device may include components such as a processor 301 of one or more processing cores, a memory 302 of one or more computer-readable storage media, a power supply 303, and an input unit 304. It should be understood by those skilled in the art that the electronic device structure shown in FIG. 8 does not constitute a limitation on the electronic device, and may include more or less components than illustrated, or may combine certain components, or different component arrangements.

The processor 301 is a control center of the electronic device. The processor 301 is connected to various parts of the entire electronic device by various interfaces and lines, and performs various functions of the electronic device and processes data by running or executing software programs and/or modules stored in the memory 302 and invoking data stored in the memory 302, thereby monitoring the electronic device as a whole. Alternatively, the processor 301 may include one or more processing cores. Preferably, the processor 301 may integrate an application processor and a modem processor, where the application processor mainly processes an operating system, a user interface, an application program, and the like, and the modem processor mainly processes wireless communication. It should be understood that the modulation/demodulation processor can be independent from the processor 301.

The memory 302 may be used to store software programs and modules, and the processor 301 executes various functional applications and data processing by running the software programs and modules stored in the memory 302. The memory 302 may mainly include a storage program area and a storage data area, where the storage program area may store an operating system, an application program (such as a sound play function, an image play function, and the like) required by at least one function, and the like; and the storage data area may store data or the like created according to the use of the electronic device. In addition, memory 302 may include a high speed random access memory, and may also include a non-volatile memory, such as at least one magnetic disk storage device, a flash memory device, or other volatile solid state storage device. Accordingly, memory 302 may also include a memory controller to provide access to the memory 302 by the processor 301.

The electronic device further includes a power supply 303 for supplying power to the respective components. Preferably, the power supply 303 may be logically connected to the processor 301 by the power supply management system, so that functions such as charging, discharging, and power consumption management are managed by the power supply management system. The power supply 303 may further include one or more direct current (DC)/or alternating current (AC) power sources, recharging system, power failure detection circuit, power converter or inverter, power supply status indicator, and the like.

The electronic device may also include an input unit 304 operable to receive input numeric or character information and to generate a signal input of a keyboard, a mouse, a joystick, an optical or a trackball related to user settings and functional control.

Although not shown, the electronic device may also include a display unit or the like, of which details are not repeatedly described herein. In the present embodiment, the processor 301 in the electronic device may load executable files corresponding to processes of one or more application programs into the memory 302 according to the following instructions, and the processor 301 executes the application programs stored in the memory 302 to implement various functions including:

obtaining at least one contour curve constituting a topographic contour of a thinning region from a contour curve set corresponding to an initial coating and thinning region of a target electrode sheet as an initial contour curve, where the contour curve set includes a plurality of contour curves constituting topographic contours of a plurality of thinning regions;

determining an initial ratio of negative electrode capacity to positive electrode capacity corresponding to the target electrode sheet according to a material region surface density corresponding to a material region in the target electrode sheet and the initial contour curve; and

determining the initial contour curve as a boundary of the initial coating and thinning region if the initial ratio of negative electrode capacity to positive electrode capacity satisfies a preset ratio of negative electrode capacity to positive electrode capacity.

It should be understood by those of ordinary skill in the art that all or some of the steps in various methods of the foregoing embodiments may be implemented by program instructions, or may be implemented by a program instructing relevant hardware. The program instructions may be stored in a computer readable storage medium, and be loaded and executed by a processor.

To this end, yet another embodiment of the present disclosure further provides a computer readable storage medium. The computer readable storage medium may be non-volatile or volatile. The storage medium may include a read-only memory (ROM), a random access memory (RAM), a magnetic disk, an optical disk, or the like. A computer program is stored thereon, and the computer program is loaded by a processor to perform the steps in the method for determining the boundary of the electrode sheet coating and thinning region provided in any one of the embodiments of the present disclosure. For example, a computer program loaded by a processor may perform the following steps:

obtaining at least one contour curve constituting a topographic contour of a thinning region from a contour curve set corresponding to an initial coating and thinning region of a target electrode sheet as an initial contour curve, where the contour curve set includes a plurality of contour curves constituting topographic contours of a plurality of thinning regions;

determining an initial ratio of negative electrode capacity to positive electrode capacity corresponding to the target electrode sheet according to a material region surface density corresponding to a material region in the target electrode sheet and the initial contour curve; and

determining the initial contour curve as a boundary of the initial coating and thinning region if the initial ratio of negative electrode capacity to positive electrode capacity satisfies a preset ratio of negative electrode capacity to positive electrode capacity.

Yet another embodiment of the present disclosure further provides a computer program product, including computer programs/instructions executable by a processor to perform steps in the method for determining the boundary of the electrode sheet coating and thinning region provided in any one of the embodiments of the present disclosure.

**Claims**

1. A method for determining a boundary of an electrode sheet coating and thinning region, **characterized in that** the method comprises:

obtaining (101) at least one contour curve constituting a topographic contour of a thinning region from a contour curve set corresponding to an initial coating and thinning region of a target electrode sheet as an initial contour curve, wherein the contour curve set comprises a plurality of contour curves constituting topographic contours of a plurality of thinning regions;

determining (102) an initial ratio of negative electrode capacity to positive electrode capacity corresponding to the target electrode sheet based on a material region surface density corresponding to a material region in the target electrode sheet and the initial contour curve; and

determining (103) the initial contour curve as a boundary of the initial coating and thinning region in response to the initial ratio of negative electrode capacity to positive electrode capacity satisfying a preset ratio of negative electrode capacity to positive electrode capacity.

2. The method of claim 1, **characterized in that** the method further comprises:
obtaining at least one contour curve constituting a topographic contour of next thinning region from the contour curve set corresponding to the initial coating and thinning region of the target electrode sheet as the initial contour curve in response to the initial ratio of negative electrode capacity to positive electrode capacity not satisfying the preset ratio of negative electrode capacity to positive electrode capacity, until the boundary of the initial coating and thinning region is determined.

3. The method of claim 1, **characterized in that** the method further comprises: before the obtaining (101) the at least one contour curve constituting the topographic contour of the thinning region from the contour curve set corresponding to the initial coating and thinning region of the target electrode sheet as the initial contour curve,

determining an initial coating and thinning region of the target electrode sheet;

performing a scanning test on the initial coating and thinning region and a material region in the target electrode sheet to measure a plurality of groups of widths of the initial coating and thinning region and thicknesses of the material region; and

performing curve fitting by taking the width of the initial coating and thinning region as an independent variable and the thickness of the material region as a dependent variable based on the plurality of groups of the widths of the initial coating and thinning region and the thicknesses of the material region to obtain the contour curve set.

4. The method of claim 3, **characterized in that** the determining (102) the initial ratio of negative electrode capacity to positive electrode capacity corresponding to the target electrode sheet based on the material region surface density corresponding to the material region in the target electrode sheet and the initial contour curve comprises:

determining a surface density of the target electrode sheet based on the material region surface density corresponding to the material region and the initial contour curve; and

determining the initial ratio of negative electrode capacity to positive electrode capacity based on the surface density of the target electrode sheet.

5. The method of claim 4, **characterized in that** the target electrode sheet comprises a positive electrode sheet and a negative electrode sheet, the material region of the target electrode sheet comprises a positive material region of the positive electrode sheet and a negative material region of the negative electrode sheet, the material region surface density comprises a material region surface density corresponding to each of the positive material region and the negative material region, and the surface density of the target electrode sheet comprises a positive surface density corresponding to the positive electrode sheet and a negative surface density corresponding to the negative electrode sheet; and

the determining (102A) the surface density of the target electrode sheet based on the material region surface density corresponding to the material region and the initial contour curve comprises: determining the positive surface density corresponding to the positive electrode sheet based on the material region surface density corresponding to the positive material region and the initial contour curve, and determining the negative surface density corresponding to the negative electrode sheet based on the material region surface density corresponding to the negative material region and the initial contour curve; and

the determining the initial ratio of negative electrode capacity to positive electrode capacity based on the surface density of the target electrode sheet comprises: determining (102B) the initial ratio of negative electrode capacity to positive electrode capacity based on the positive surface density and the negative surface density.

6. The method of claim 5, **characterized in that** the initial coating and thinning region comprises a positive thinning region corresponding to the positive electrode sheet and a negative thinning region corresponding to the negative electrode sheet; and the determining (102A) the positive surface density corresponding to the positive electrode sheet based on the material region surface density corresponding to the positive material region and the initial contour curve, and the determining the negative surface density corresponding to the negative electrode sheet based on the material region surface density corresponding to the negative material region and the initial contour curve comprise:

determining (102A1) the positive thinning region surface density corresponding to the positive thinning region based on the material region surface density corresponding to the positive material region and the initial contour curve;

determining (102A2) the negative thinning region surface density corresponding to the negative thinning region based on the material region surface density corresponding to the negative material region and the initial contour curve;

determining (102A3) the positive surface density based on the positive thinning region surface density and the material region surface density corresponding to the positive material region; and

determining (102A4) the negative surface density based on the negative thinning region surface density and the material region surface density corresponding to the negative material region.

7. The method of claim 6, **characterized in that** the initial contour curve comprises a positive contour curve corresponding to the positive thinning region; and the determining (102A1) the positive thinning region surface density corresponding to the positive thinning region based on the material region surface density corresponding to the positive material region and the initial contour curve comprises:

determining (102A11) a positive cross-sectional area corresponding to the positive thinning region based on the positive contour curve; and
determining (102A12) the positive thinning region surface density based on the positive contour curve, the positive cross-sectional area, and the material region surface density corresponding to the positive material region.

8. The method of claim 7, **characterized in that** the determining (102A11) the positive cross-sectional area corresponding to the positive thinning region based on the positive contour curve comprises:
performing integral calculation on the positive contour curve to obtain the positive cross-sectional area.

9. The method of claim 7, **characterized in that** the determining (102A12) the positive thinning region surface density based on the positive contour curve, the positive cross-sectional area, and the material region surface density corresponding to the positive material region comprises:

obtaining interval endpoint values corresponding to an independent variable in the positive contour curve;
determining interval endpoint values corresponding to a dependent variable in the positive contour curve based on the interval endpoint values corresponding to the independent variable in the positive contour curve;
determining a width of the initial coating and thinning region and a thickness of the positive material region based on the interval endpoint values corresponding to each of the independent variable and the dependent variable in the positive electrode contour curve, to obtain a width value corresponding to the positive coating and thinning region and a thickness value corresponding to the positive material region; and
determining the positive thinning region surface density the based on a product of the width value corresponding to the positive coating and thinning region and the thickness value corresponding to the positive material region, the material region surface density corresponding to the positive material region, and the positive cross-sectional area.

10. The method of claim 6, **characterized in that** the initial contour curve comprises a negative contour curve corresponding to the negative thinning region; and the determining (102A2) the negative surface density based on the negative thinning region surface density and the material region surface density corresponding to the negative material region comprises:

determining a negative cross-sectional area corresponding to the negative thinning region based on the negative contour curve; and
determining the negative thinning region surface density based on the negative contour curve, the negative cross-sectional area, and the material region surface density of the negative material region.

11. The method of claim 10, **characterized in that** the determining the negative thinning region surface density based on the negative contour curve, the negative cross-sectional area, and the material region surface density of the negative material region comprises:

obtaining interval endpoint values corresponding to an independent variable in the negative contour curve;
determining interval endpoint values corresponding to a dependent variable in the negative contour curve based on the interval endpoint values corresponding to the independent variable in the negative contour curve;
determining a width of the initial coating and thinning region and a thickness of the negative material region based on the interval endpoint values corresponding to each of the independent variable and the dependent variable in the negative electrode contour curve, to obtain a width value corresponding to the negative coating and thinning region and a thickness value corresponding to the negative material region; and
determining the negative thinning region surface density based on a product of the width value corresponding to the negative coating and thinning region and the thickness value corresponding to the negative material region, the material region surface density of the negative material region, and the negative cross-sectional area.

12. An apparatus (200) for determining a boundary of an electrode sheet coating and thinning region, **characterized in that** the apparatus (200) comprises:

an obtaining module (201) for obtaining (101) at least one contour curve constituting a topographic contour of a thinning region from a contour curve set corresponding to an initial coating and thinning region of a target electrode sheet as an initial contour curve, wherein the contour curve set comprises a plurality of contour curves constituting topographic contours of a plurality of thinning regions;
a first determination module (202) for determining (102) an initial ratio of negative electrode capacity to positive electrode capacity corresponding to the target electrode sheet based on a material region surface density corresponding to a material region in the target electrode sheet and the initial contour curve; and
a second determination module (203) for determining (103) the initial contour curve as a boundary of the initial coating and thinning region in response to the initial ratio of negative electrode capacity to positive electrode capacity satisfying a preset ratio of negative electrode capacity to positive electrode capacity.

13. An electronic device, **characterized in that** the electronic device comprises:

one or more processors (301);
a memory (302); and
one or more application programs, wherein the one or more application programs are stored in the memory (302) and configured to be executed by the processors (301) to implement the method of any one of claims 1 to 11.

14. A non-transitory computer readable storage medium having stored thereon a computer program loaded by a processor to perform the method of any one of claims 1 to 11.

Obtaining at least one contour curve constituting a topographic contour of a thinning region from a contour curve set corresponding to an initial coating and thinning region of a target electrode sheet as an initial contour curve — 101

Determining an initial ratio of negative electrode capacity to positive electrode capacity corresponding to the target electrode sheet according to a material region surface density corresponding to a material region in the target electrode sheet and the initial contour curve — 102

Determining the initial contour curve as a boundary of the initial coating and thinning region if the initial ratio of negative electrode capacity to positive electrode capacity satisfies a preset ratio of negative electrode capacity to positive electrode capacity — 103

FIG. 1

A1

h(x)

h

A2

Material region

Topographic contour of thinning region

b

O

x

FIG.2

FIG.3

Determining the positive surface density corresponding to the positive electrode sheet according to the material region surface density corresponding to the positive material region and the initial contour curve, and determining the negative surface density corresponding to the negative electrode sheet according to the material region surface density corresponding to the negative material region and the initial contour curve — 102A

Determining the initial ratio of negative electrode capacity to positive electrode capacity according to the positive surface density and the negative surface density — 102B

FIG.4

Determining the positive thinning region surface density corresponding to the positive thinning region according to the material region surface density corresponding to the positive material region and the initial contour curve ⎯102A1

Determining the negative thinning region surface density corresponding to the negative thinning region according to the material region surface density corresponding to the negative material region and the initial contour curve ⎯102A2

Determining the positive surface density according to the positive thinning region surface density and the material region surface density corresponding to the positive material region ⎯102A3

Determining the negative surface density according to the negative thinning region surface density and the material region surface density corresponding to the negative material region ⎯102A4

FIG.5

Determining a positive cross-sectional area corresponding to the positive thinning region according to the positive contour curve ⌐102A11

Determining the positive thinning region surface density according to the positive contour curve, the positive cross-sectional area, and the material region surface density corresponding to the positive material region ⌐102A12

FIG.6

201

Obtaining module

202

First determination module

203

Second determination module

Apparatus for determining boundary of electrode sheet coating and thinning region

FIG.7

303

301

302

Power supply

Memory

Processor

Input unit

304

FIG.8

# EUROPEAN SEARCH REPORT

**Application Number**

EP 24 21 6980

## DOCUMENTS CONSIDERED TO BE RELEVANT

| Category | Citation of document with indication, where appropriate, of relevant passages | Relevant to claim |
|---|---|---|
| X | CN 117 387 542 A (EVE ENERGY CO LTD) 12 January 2024 (2024-01-12) * claims 1-10; figures 1-6 * ----- | 1,12-14 |
| A | CN 115 808 126 B (HANGZHOU BAIZIJIAN TECH CO LTD) 30 May 2023 (2023-05-30) * claims 1-6; figures 1-11 * ----- | 1-14 |

**CLASSIFICATION OF THE APPLICATION (IPC)**

INV.
H01M4/04
G01B11/24
G06T7/62
H01M4/139
H01M10/0525

ADD.
H01M4/02

**TECHNICAL FIELDS SEARCHED (IPC)**

H01M
G01B
G06T

The present search report has been drawn up for all claims

| Place of search | Date of completion of the search | Examiner |
|---|---|---|
| Munich | 12 August 2025 | Szekely, Noemi Kinga |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

    .......................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 6980

This annex lists the patent family members relating to the patent documents cited in the above-mentioned European search report.
The members are as contained in the European Patent Office EDP file on
The European Patent Office is in no way liable for these particulars which are merely given for the purpose of information.

12-08-2025

| Patent document cited in search report | | Publication date | Patent family member(s) | Publication date |
|---|---|---|---|---|
| CN 117387542 | A | 12-01-2024 | NONE | |
| CN 115808126 | B | 30-05-2023 | NONE | |

EPO FORM P0459

For more details about this annex : see Official Journal of the European Patent Office, No. 12/82